# EUROPÄISCHE PATENTSCHRIFT

(11) **EP 2 002 580 B1**
(45) Veröffentlichungstag und Bekanntmachung des Hinweises auf die Patenterteilung: **17.08.2011**
(21) Anmeldenummer: 07711896.6
(22) Anmeldetag: 09.03.2007
(51) Int. Cl.: H04H 20/20, H03H 7/00

(54) **SYNCHRONISIERANORDNUNG FÜR DIE HOCHFREQUENZ-SENDER EINES GLEICHWELLEN-NETZES**
SYNCHRONIZING ASSEMBLY FOR THE HIGH-FREQUENCY TRANSMITTERS OF A COMMON FREQUENCY NETWORK
DISPOSITIF DE SYNCHRONISATION POUR ÉMETTEUR HAUTE FRÉQUENCE D'UN RÉSEAU DE FRÉQUENCE COMMUNE

(30) Priorität: 03.04.2006 DE 102006015393
(43) Veröffentlichungstag der Anmeldung: 17.12.2008
(73) Patentinhaber: Rohde & Schwarz GmbH & Co. KG, 81671 München (DE)
(72) Erfinder: HEINEMANN, Cornelius, 85435 Erding (DE); BÖHM, Wolfgang, 85635 Siegertsbrunn (DE)
(74) Vertreter: Körfer, Thomas
(86) Internationale Anmeldenummer: PCT/EP2007/002099
(87) Internationale Veröffentlichungsnummer: WO 2007/115626

(56) Entgegenhaltungen:
- EP-A1- 0 653 845
- US-A- 5 261 118
- "ATSC STANDARD: SYNCHRONIZATION STANDARD FOR DISTRIBUTED TRANSMISSION" ATSC STANDARD, 14. Juli 2004 (2004-07-14), Seiten 1-54, XP001202456

## Beschreibung

Die Erfindung betrifft eine Anordnung laut Oberbegriff des Hauptanspruches.

Die Aussendung von digitalen Video- und Audio- sowie anderen digitalen Daten über terrestrische Hochfrequenzsender ist für die USA und andere Länder wie Kanada, Süd-Korea oder Brasilien durch den ATSC (Advanced Television Systems Committee, Washington)-Standard geregelt (ATSC-Standard A/53). Dieser Standard wird bisher praktisch nur bei digitalen Fernsehsendern benutzt, die jeweils mit unterschiedlicher Frequenz senden. Die Nachfrage nach immer mehr teilweise eng benachbarten terrestrischen Fernsehsendern hat auch in den USA zwischenzeitlich dazu geführt, zur Datenübertragung sog. Gleichwellen-Netze einzuführen, bei denen innerhalb desselben Netzes zur gleichen Zeit auf der gleichen Sendefrequenz mehrere Sender dieselbe Information ausstrahlen. Neben einer exakten Frequenzsynchronisation ist dafür auch eine exakte Zeitsynchronisation erforderlich, damit der digitale Datenstrom von allen Sendern des Netzes exakt synchron abgestrahlt wird.

Für diese Zeitsynchronisation unter Beibehaltung des ATSC-Standards existieren schon verschiedene Vorschläge. Diesen Vorschlägen ist gemeinsam, den auszusendenden digitalen Datenstrom nicht mehr als kontinuierlichen Datenstrom den Sendern zuzuführen sondern vielmehr in einer Zentrale den auszusendenden digitalen Datenstrom in periodisch aufeinanderfolgende Datenrahmen aufzuteilen und zwar gesteuert durch eine beispielsweise vom GPS (Global Position System)-System abgeleitete Zeitreferenz (1 pps-Sekundenimpuls zusammen mit der über GPS übertragenen Referenzfrequenz von 10 MHz). In diese Datenrahmen werden an bestimmten Stellen der Datenpakete sog. Synchronisier-Zeitstempel eingesetzt. Die so aufbereiteten Datenrahmen werden dann über ein geeignetes Verteilernetz (Kabel, Funkstrecken, Satellitenstrecken etc.) aus der Zentrale zu den einzelnen Hochfrequenzsendern übertragen. In den einzelnen Sendern werden diese Datenrahmen einer Signalverarbeitungseinrichtung mit Verzögerungsglied zugeführt. Sie werden dort entsprechend dem ATSC-Standard kodiert und moduliert.

Außerdem wird in den Sendern der nach der Norm sich ergebende Soll-Aussendezeitpunkt, zu dem die Datenrahmen am Ausgang der einzelnen Sender ausgesendet werden sollen, berechnet und zwar aus den in den Datenrahmen eingesetzten Synchronisier-Zeitstempeln in Bezug auf die gleiche Zeitreferenz, wie sie auch in der Zentrale benutzt wurde, also wieder beispielsweise in Bezug auf den 1 pps-Sekundenimpuls des GPS-Systems. Der so berechnete Soll-Aussendezeitpunkt bestimmt die notwendige Verzögerung der Datenrahmen in der Verzögerungseinrichtung. Die in der Verzögerungseinrichtung verzögerten Datenrahmen werden schließlich mit einem Systemtakt, der durch einen im Sender vorgesehenen frei schwingenden Taktgenerator, der beispielsweise wieder über die 10 MHz-Referenzfrequenz des GPS-Systems synchronisiert ist, dem Ausgang des Senders zugeführt und schließlich dort über die Antenne abgestrahlt.

Erste Versuche mit diesen bekannten Vorschlägen zur Ergänzung des ATSC-Standards für Gleichwellen-Netze haben ergeben, dass es häufig zu Kurzzeitunterbrechungen des ausgesendeten Signals kommt. Diese bekannten Vorschläge funktionieren nämlich nur dann stabil, wenn alle Signale exakt synchron zueinander sind, also sowohl die Datenrate und Rahmenlänge des Datensignals, die Zeitreferenz (1 pps des GPS-Empfängers) und der im Sender selbst erzeugte Systemtakt des Taktgenerators, mit dem das Sendesignal ausgestrahlt wird. In der Praxis ist dies jedoch häufig nicht der Fall, denn viele GPS-Empfänger liefern den 1 Sekunden-Impuls 1 pps und auch die Referenzfrequenz 10 MHz nicht wirklich synchron. Der für das Auslesen der Datenrahmen aus der Verzögerungseinrichtung vorgesehene "krummwertige" Systemtakt kann somit nicht immer hundertprozentig exakt generiert werden und auch die Zuführungsstrecken von der Zentrale zu den Sendern können die Datenrate und damit die Rahmenperiode des Datensignals beispielsweise durch Dopplereffekte bei Satellitenzuführung und dergleichen verändern. Die Konsequenz ist, dass die im Sender berechnete und am Verzögerungsglied eingestellte Verzögerungszeit nicht mehr korrekt ist, sondern mehr oder weniger stark vom Sollwert abweicht. Bei den bekannten Systemen ist zwar vorgesehen, dass in diesen Fällen eine neue Verzögerungszeit berechnet und eingestellt wird. Dies bedeutet aber eine Unterbrechung des Sendesignals, was zu den erwähnten Störungen führt.

Das Dokument ATSC STANDARD: SYNCHRONIZATION STANDARD FOR DISTRIBUTED TRANSMISSION" ATSC STANDARD, 14. Juli 2004 offenbart den Oberbegriff des Anspruchs 1.

Aus dieser Schrift ist auch bekannt, dass in jedem Sender ein Systemtakt aus den empfangenden Daten abgeleitet wird. Mittels eines FIFO buffers wird eine variable Verzögerung bereit gestellt.

EP653845 (ATT Corp) bezieht sich ebenfalls auf die Synchronisierung eines Gleichwellen - Netzes. In dieser Schrift wird eine lokale Ist -Zeit, sogenannte "microcell time of day", mit einer empfangenden Soll -Zeit verglichen. Bei Feststellung einer Abweichung wird der Taktgenerator des Senders mittels einer Regelschleife so eingestellt, dass Ist-Zeit und Soll -Zeit übereinstimmen.

Es ist daher die Aufgabe der Erfindung, die bisher bekannten Vorschläge für die Ergänzung des ATSC-Standards für den Gleichwellen-Netzaufbau so zu verbessern, dass solche Signalunterbrechungen mit Sicherheit vermieden werden.

Diese Aufgabe wird ausgehend von einer Anordnung laut Oberbegriff des Hauptanspruchs durch dessen kennzeichnende Merkmale gelöst. Eine vorteilhafte Weiterbildung ergeben sich aus den Unteransprüchen.

Gemäß der Erfindung wird mit einer einfachen Regelschaltung durch Vergleich des tatsächlichen Ist-Aussendezeitpunktes am Ausgang des Senders mit dem in bekannter Weise im Sender berechneten Soll-Aussendezeitpunkt der im Sender örtlich erzeugte Systemtakt so geregelt, dass evtl. Zeitverschiebungen automatisch ausgeregelt werden. Die Systemtaktänderung liegt dabei im mHz-Bereich, damit das Gleichwellennetz selbst nicht gestört wird. Dies reicht jedoch aus, um Zeitfehler im Bereich von ±10 ms auszuregeln. Für größere Ablagen wird wie bisher die Zeitverzögerung entsprechend angepasst. Mit der erfindungsgemäßen Regelung werden Signalunterbrechungen vermieden. Die Rückregelung des Ist-Aussendezeitpunkts auf den berechneten Soll-Aussendezeitpunkt kann je nach Größe der Ablage in mehreren aufeinanderfolgenden Schritten innerhalb mehrere aufeinanderfolgender Datenrahmen erfolgen.

Die Erfindung wird im folgenden anhand einer schematischen Zeichnung an einem Ausführungsbeispiel näher erläutert. In der Zeichnung zeigt:

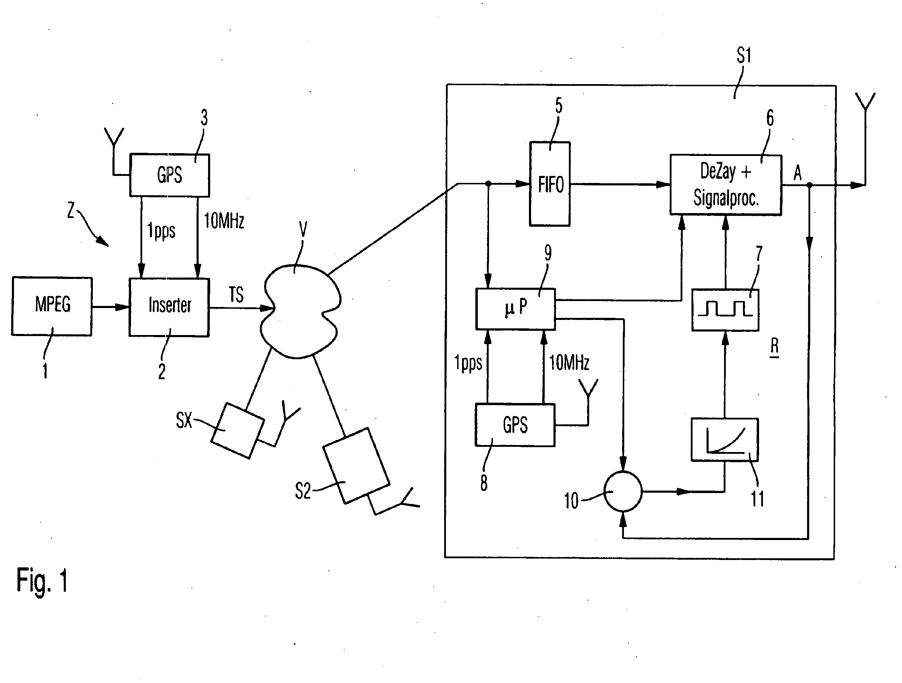

- Fig. 1: den Prinzipaufbau eines nach dem ATSC-Standard arbeitenden Gleichwellennetzes, wobei jedem der dabei verwendeten Hochfrequenzsender ein erfindungsgemäßer Regelkreis zugeordnet ist.

Nach den eingangs erwähnten bekannten Vorschlägen wird der auszusendende digitale Datenstrom beispielsweise aus einer MPEG (Moving Pictures Expert Group)-Quelle 1 in einer Zentrale Z einem Inserter 2 zugeführt, in welchem gesteuert durch den 1 pps-Impuls eines GPS-Empfängers 3 und dessen 10 MHz-Referenzfrequenz ein Datenstrom TS in Form von periodisch aufeinanderfolgenden Datenrahmen mit in jedem dieser Datenrahmen an ausgewählten Datenpaketen beispielsweise jeweils im letzten 623igsten Transportstrompaket eines jeden Datenrahmens eingesetzten Synchronisier-Zeitstempeln erzeugt wird. Diese Folge von Datenrahmen mit eingesetzten Synchronisier-Zeitstempeln werden über ein Verteilernetz V zu den einzelnen Sendern S1 bis SX übertragen, dort in Hochfrequenzsignale umgesetzt und über Antennen abgestrahlt. Im Beispiel ist nur ein Sender S1 im Detail dargestellt, in der Praxis können über das Verteilernetz V jedoch beliebig viele Sender mit dem zentralen Datenstrom TS gespeist werden. Alle Sender S1 bis SX strahlen jeweils das gleiche Programm mit der gleichen Sendefrequenz ab.

In jedem Sender wird der ankommende Datenrahmen-Strom zur Taktentkopplung in einen Eingangsdatenpuffer 5 eingelesen und von dort einer Signalverarbeitungs- und Verzögerungseinrichtung 6 zugeführt, die über einen Systemtaktgenerator 7 taktgesteuert ist. In der Signalverarbeitungseinrichtung wird der ankommende Datenrahmen-Strom entsprechend dem ATSC-Standard kodiert und moduliert und dann am Ausgang A dieser Einrichtung 6 als Hochfrequenz-, Zwischenfrequenz- bzw. Basisbandsignal ausgegeben und schließlich zur Abstrahlung gebracht. Wesentlich ist, dass die nach diesem Ausgang A der Einrichtung 6 folgenden Verarbeitungseinheiten wie Verstärker, Frequenzumsetzer und dergleichen eine konstante Durchlaufzeit aufweisen.

In der durch den Systemtakt 7 getakteten Verzögerungseinrichtung 6 werden die Datenrahmen nach den eingangs erwähnten Vorschlägen um eine im Sender berechnete Verzögerungszeit zeitlich verzögert. Die Verzögerungszeit berechnet sich aus den Synchronisier-Zeitstempeln der Datenrahmen in Bezug zu der in der Zentrale benutzten Zeitreferenz, die ihrerseits in jedem Sender wieder über einen GPS-Empfänger 8 in einer Berechnungsschaltung 9 ausgewertet wird. Mit der so berechneten Verzögerungszeit wird die Verzögerung in der Verzögerungseinrichtung G eingestellt.

Diese bisher beschriebene Anordnung entspricht den eingangs erwähnten bekannten Vorschlägen für die Erweiterung des ATSC-Systems und besitzt auch die eingangs erwähnten Nachteile der Signalunterbrechung in Folge der Notwendigkeit einer Neuberechnung der Verzögerungszeit bei auftretenden Signalabweichungen.

Gemäß der Erfindung ist nun in jedem einzelnen Sender zusätzlich ein Regelkreis R vorgesehen, bei dem in einem Zeitkomparator 10 der in der Berechnungsschaltung 9 berechnete Soll-Aussendezeitpunkt mit dem Ist-Aussendezeitpunkt am Ausgang A der Signalverarbeitungs- und Verzögerungseinrichtung 6 verglichen wird. Bei einer zeitlichen Abweichung von Ist-Wert zu Soll-Wert im µs-Bereich wird über ein Regelglied 11 mit einer vorbestimmten Regelcharakteristik eine Stellgröße für den Systemtaktgenerator 7 erzeugt und der Systemtakt so geregelt, dass der Beginn der Aussendung jedes Datenrahmens in jedem Sender kontinuierlich jeweils auf den Soll-Aussendezeitpunkt geregelt wird, ohne dass die Verzögerung in der Verzögerungseinrichtung G neu eingestellt wird.

Wird über den Komparator 10 festgestellt, dass der Ist-Aussendezeitpunkt um einige µs später als durch den Soll-Aussendezeitpunkt vorgegeben abgestrahlt wird, so wird über den Regelkreis R der Systemtakt erhöht und somit das Ausgangssignal früher ausgesendet, umgekehrt wird das Ausgangssignal später gesendet, wenn der Systemtakt um einige mHz abgesenkt wird.

Die Regelcharakteristik des Regelgliedes 11 wird je nach Bedarf beispielsweise so gewählt, dass eine festgestellte Abweichung bereits nach einigen wenigen Datenrahmen ausgeregelt ist. In manchen Fällen ist es ausreichend, die Ausregelung in kleineren Schritten verteilt über mehrere aufeinanderfolgende Datenrahmen durchzuführen.

## Patentansprüche

1. Anordnung zum Synchronisieren des Aussendezeitpunktes des digitalen Datenstromes in den einzelnen nach dem ATSC-Standard arbeitenden und jeweils auf gleicher Frequenz gleiche Daten sendenden Hochfrequenz-Sendern eines Gleichwellen-Netzes, bei dem der in einer Zentrale (Z) erzeugte digitale Datenstrom (TS) in Form von periodisch aufeinanderfolgenden Datenrahmen den einzelnen Hochfrequenz- Sendern (S1 , SX) zugeführt wird und der Soll-Aussendezeitpunkt in den Sendern aus einem in der Zentrale in die Datenrahmen eingesetzten Synchronisier-Zeitstempel sowie einer sowohl in der Zentrale als auch in den Sendern benutzten Zeitreferenz berechnet wird, während die Aussendung der Datenrahmen am Ausgang (A) der Hochfrequenz-Sender durch einen in den Hochfrequenz-Sendern erzeugten Systemtakt bestimmt ist,
**dadurch gekennzeichnet,**
**dass** in jedem Hochfrequenz-Sender (S1, SX) der Soll-Aussendezeitpunkt mit dem durch den Systemtakt bestimmten Ist-Aussendezeitpunkt der Datenrahmen am Ausgang (A) der Hochfrequenz-Sender verglichen wird und in Abhängigkeit davon mittels eines Regelkreises (R) die Taktfrequenz eines Taktgenerators (7) so geregelt wird, dass der durch den Systemtakt bestimmte Ist-Aussendezeitpunkt mit dem berechneten Soll-Aussendezeitpunkt übereinstimmt.

2. Anordnung nach Anspruch 1,
**dadurch gekennzeichnet,**
**dass** bei dem in der Zentrale (Z) aus dem auszusendenden digitalen Datenstrom gesteuert durch die sowohl in der Zentrale als auch in den einzelnen Hochfrequenz-Sendern (S1, SX) benutzte Zeitreferenz (1 pps) periodisch aufeinander folgende Datenrahmen mit eingesetzten Synchronisier-Zeitstempeln erzeugt und über ein Verteilernetz (V) zu den einzelnen Hochfrequenz-Sendern übertragen werden, wobei in den Hochfrequenz-Sendern diese Datenrahmen einer Verzögerungseinrichtung (6) zugeführt werden, in welcher die Datenrahmen um eine aus dem Synchronisier-Zeitstempel im Bezug auf die Zeitreferenz berechnete Verzögerungszeit, die dem Soll-Aussendezeitpunkt entspricht, verzögert werden und aus der die Datenrahmen gesteuert durch den Systemtakt eines Taktgenerators (7) am Ausgang (A) der Sender ausgesendet werden.

3. Anordnung nach Anspruch 2,
**dadurch gekennzeichnet,**
**dass** der in den Sendern berechnete Soll-Aussendezeitpunkt mit dem durch den Systemtakt bestimmten Ist-Aussendezeitpunkt der Datenrahmen am Ausgang (A) des Senders in einem Zeitkomparator (10) verglichen wird und über diesen Zeitkomparator (10) und ein Regelglied (11) eine Stellgröße für den Systemtaktgenerator (7) erzeugt wird, derart, dass die Taktfrequenz des Systemtaktgenerators (7) so geregelt wird, dass der durch den Systemtakt bestimmte Ist-Aussendezeitpunkt der Datenrahmen am Ausgang (A) jedes Hochfrequenz-Senders jeweils mit dem berechneten Soll-Aussendezeitpunkt übereinstimmt.

## Claims

1. Arrangement for synchronising the transmission time of the digital data stream in the individual high-frequency transmitters of a common-wave network operating according to the ATSC standard and transmitting respectively identical data at an identical frequency, wherein the digital data stream (TS) generated in a master station (Z) is supplied to the individual high-frequency transmitters (S1, SX) in the form of a periodic succession of data frames, and the setpoint transmission time is calculated in the transmitters from a synchronising time stamp inserted into the data frames within the master station and from a time reference used both in the master station and also in the transmitters, while the transmission of the data frames at the output (A) of the high-frequency transmitter is determined by a system clock generated in the high-frequency transmitters,
**characterised in that**
the setpoint transmission time in each high-frequency transmitter (S1, SX) is compared with the actual transmission time determined by the system clock of the data frames at the output (A) of the high-frequency transmitter and, dependent upon this comparison, the clock frequency of clock generator (7) is regulated by means of a regulating circuit (R) in such a manner that the actual transmission time determined by the system clock corresponds with the calculated setpoint transmission time.

2. Arrangement according to claim 1,
**characterised in that**,
within the master station (Z), periodic successions of data frames with inserted synchronising time stamps are generated from the digital data stream to be transmitted in a manner controlled by the time reference (1 pps) used both in the master station and also in the individual high-frequency transmitters (S1, SX) and transmitted via a distribution network (V) to the individual high-frequency transmitters,
wherein, within the high-frequency transmitters, these data frames are supplied to a delay unit (6), in which the data frames are delayed by a delay time calculated from the synchronising time stamp with reference to the time reference and corresponding to the setpoint transmission time, and from which the data frames are transmitted at the output (A) of the transmitters in a manner controlled by the system clock of a clock generator (7).

3. Arrangement according to claim 2,
**characterised in that**
the setpoint transmission time calculated in the transmitters is compared in a time comparator (10) with the actual transmission time of the data frames at the output (A) of the transmitter determined by the system clock, and an adjustment parameter for the system clock generator (7) is generated via this time comparator (10) and a regulating element (11) in such a manner that the clock frequency of the system clock generator (7) is regulated in such a manner that the actual transmission time of the data frames at the output (A) of every high-frequency transmitter determined by the system clock corresponds in every case with the calculated setpoint transmission time.

## Revendications

1. Dispositif de synchronisation d'un moment d'émission du flux numérique de données dans les différents émetteurs haute fréquence fonctionnant selon le standard ATSC et émettant les mêmes données respectivement sur la même fréquence d'un réseau à fréquence commune, dans lequel le flux numérique de données (TS) généré dans une centrale (Z) sous la forme de trames de données consécutives périodiques est délivré aux différents émetteurs (SI, SX) et le moment d'émission de consigne dans les émetteurs est calculé à partir d'un horodateur de synchronisation inséré dans les trames de données dans la centrale ainsi qu'à partir d'une référence temporelle utilisée non seulement dans la centrale mais également dans les émetteurs, alors que l'émission des trames de données est déterminée à la sortie (A) des émetteurs de haute fréquence par une horloge de système générée dans les émetteurs,
**caractérisé en ce que**
dans chaque émetteur de haute fréquence (SI, SX), le moment d'émission de consigne est comparé au moment d'émission réel déterminé par l'horloge du système de haute fréquence des trames de données à la sortie (A) de l'émetteur et en conséquence la fréquence d'horloge d'un générateur d'horloge (7) est réglée grâce à un circuit de réglage (R), de sorte que le moment d'émission réel déterminé par l'horloge du système coïncide avec le moment d'émission de consigne calculé.

2. Dispositif selon la revendication 1, **caractérisé en ce que**
les trames de données consécutives périodiques sont générées dans la centrale (Z) avec un horodateur de synchronisation inséré à partir du flux numérique de données à émettre contrôlé par la référence temporelle (1 pps) utilisée non seulement dans la centrale mais également dans
les différents émetteurs de haute fréquence (SI, SX) et transmises aux différents émetteurs par l'intermédiaire d'un réseau de distribution (V), dans lequel, dans les émetteurs de haute fréquence, ces trames de données sont délivrées à un dispositif de retard (6), dans lequel les trames de données sont retardées d'un temps de retard calculé à partir de l'horodateur de synchronisation par rapport à la référence temporelle, qui correspond au moment d'émission de consigne, et à partir de là, les trames de données contrôlées par l'horloge de système d'un générateur d'horloge (7) sont envoyées à la sortie (A) des émetteurs de haute fréquence.

3. Dispositif selon la revendication 2, **caractérisé en ce que**
le moment d'émission de consigne calculé dans les émetteurs est comparé au moment d'émission réel déterminé par l'horloge de système des trames de données à la sortie (A) de l'émetteur d'un comparateur de temps (10) et, grâce à ce comparateur de temps (10) et d'un élément de réglage (11), une valeur de réglage pour le générateur d'horloge de système (7) est générée, de sorte que la fréquence d'horloge du générateur d'horloge de système (7) est réglée, de sorte que le moment d'émission réel déterminé par l'horloge du système des trames de données à la sortie (A) de chaque émetteur haute fréquence coïncide respectivement avec le moment d'émission de consigne calculé.
